# EUROPÄISCHE PATENTSCHRIFT

(11) **EP 3 918 889 B1**
(45) Veröffentlichungstag und Bekanntmachung des Hinweises auf die Patenterteilung: **27.09.2023**
(21) Anmeldenummer: 20701743.5
(22) Anmeldetag: 23.01.2020
(51) Int. Cl.: H05K 7/14, H05K 7/20

(54) **VERBINDUNGSANORDNUNG ZUM VERBINDEN EINER STROMSCHIENE MIT EINEM GEHÄUSE**
CONNECTION ARRANGEMENT FOR CONNECTING A BUSBAR TO A HOUSING
SYSTÈME DE CONNEXION DESTINÉ À CONNECTER UNE BARRE OMNIBUS À UN BOÎTIER

(30) Priorität: 28.01.2019 DE 102019101973
(43) Veröffentlichungstag der Anmeldung: 08.12.2021
(73) Patentinhaber: Eugen Forschner GmbH, 78549 Spaichingen (DE)
(72) Erfinder: DOPADLO, Martin, 78549 Spaichingen (DE); STRUMBERGER, Heike, 78549 Spaichingen (DE)
(74) Vertreter: Keller Schneider Patentanwaltsgesellschaft mbH
(86) Internationale Anmeldenummer: PCT/EP2020/051606
(87) Internationale Veröffentlichungsnummer: WO 2020/156917

(56) Entgegenhaltungen:
- DE-U1-202008 016 048
- US-A1- 2006 039 127
- US-A1- 2006 239 050
- US-A1- 2017 201 083
- US-A1- 2019 020 285

## Beschreibung

Die Erfindung betrifft eine Verbindungsanordnung zum Verbinden einer Stromschiene mit einem Gehäuse gemäß dem Oberbegriff des Patentanspruchs 1.

Eine gattungsgemäße Verbindungsanordnung ist aus EP 2 871 921 B1 bekannt. Darin wird ein Gehäuse für elektrische Komponenten, umfassend einen elektrisch isolierenden Körper, einen Gehäusekörper und eine Sammelschiene beschrieben. Dabei sind der Gehäusekörper und der elektrisch isolierende Körper einstückig miteinander verbunden und die Sammelschiene ist in den elektrisch isolierenden Körper eingebettet. Die beanspruchte Verbindungsanordnung ist somit nicht zerstörungsfrei voneinander lösbar ausgebildet, was bei Wartungs- und/oder Reparaturarbeiten sowie für das Recycling einen wesentlichen Nachteil darstellt.

Eine weitere Verbindungsanordnung ist aus der US 2019 / 020 285 A1 bekannt. Dort wird ein Leistungselektronik-Submodul mit einer Schalteinrichtung beschrieben. Ein Substrat der Schalteinrichtung umfasst eine erste und eine zweite Gleichspannungsleiterplatte, mit denen ein erstes und ein zweites Gleichspannungsanschlusselement verbunden sind. Das Substrat enthält ferner einen gedruckten Wechselspannungsleiter, mit dem ein Wechselspannungsanschlusselement verbunden ist.

Eine weitere Verbindungsanordnung ist aus der US 2017 / 201 083 A1 bekannt. Der dort beschriebene Leistungswandler weist Stromschienen auf, die eine Doppelfunktion haben. Sie kühlen die elektronischen Schalter und leiten Strom zu der von den elektronischen Schaltern. Bei den elektronischen Schaltern, die in einem Gehäuse untergebracht sind, ist die große Lasche des Gehäuses direkt an die Stromschiene gelötet oder anderweitig befestigt.

Aufgabe der Erfindung ist es, eine gut wärmeleitende und leicht montierbare Verbindungsanordnung zu schaffen.

Diese Aufgabe wird erfindungsgemäß durch eine Verbindungsanordnung mit den Merkmalen des Anspruchs 1 gelöst. Vorteilhafte Ausgestaltungen der Erfindung sind in den Unteransprüchen angegeben.

Ein Einsatzgebiet der Erfindung sind beispielsweise Anwendungen im Automobilbereich, insbesondere Anwendungen in der Elektromobilität.

Mit der vorliegenden Erfindung ist es möglich, eine gut wärmeleitende, reparaturfreundliche Verbindungsanordnung zur Befestigung einer Stromschiene und optional weiterer elektrischer, elektromechanischer oder elektronischer Komponenten - wie beispielsweise Sicherungen oder Schütze - an einer Wand eines Gehäuses zu schaffen. Vom Begriff "Stromschiene" im Sinne dieser Erfindung werden auch andere elektrisch leitende Bauteile umfasst.

Die erfindungsgemäße Verbindungsanordnung umfasst eine Stromschiene, wenigstens eine Wand eines Gehäuses, wenigstens ein elektrisch isolierendes Element und wenigstens ein zum Verbinden der Stromschiene mit dem Gehäuse dienendes Befestigungselement.

Die Erfindung zeichnet sich dadurch aus, dass die Verbindungsanordnung wenigstens ein Befestigungselement zur Verbindung mit der Wand des Gehäuses aufweist und dass das wenigstens eine elektrisch isolierende Element aus einem thermisch gut leitenden Werkstoff ausgebildet ist. Ein gut thermisch leitender Werkstoff hat beispielsweise eine Leitfähigkeit ab etwa 1,5 W/(m·K) oder mehr.

Eine lösbare Verbindungsanordnung ist besonders im Falle von Wartungs- und/oder Reparaturarbeiten und auch beim Recycling von großem Vorteil. Das elektrisch isolierende Element gleichzeitig aus einem thermisch gut leitfähigen Werkstoff zu gestalten, ermöglicht eine Wärmeableitung der in der Stromschiene erzeugten Wärme hin zur Wand des Gehäuses und verhindert so ein Überhitzen der Stromschiene, wenigstens eines im Gehäuse angeordneten elektrischen Bauteils und weiterer darin angeordneter elektrischer Komponenten.

Erfindungsgemäß weist die Verbindungsanordnung wenigstens zwei Befestigungselemente auf, wobei wenigstens ein erstes Befestigungselement die Stromschiene, optional das elektrische Bauteil, und das elektrisch isolierende Element miteinander verbindet und ein zweites Befestigungselement das elektrisch isolierende Element mit der Wand des Gehäuses verbindet. In diesem Fall erfolgt die Befestigung der Stromschiene in zwei Schritten, wobei zuerst das elektrisch isolierende Element mit der Wand des Gehäuses und dann die Stromschiene mit dem elektrisch isolierenden Element verbunden wird.

Gemäß einer vorteilhaften Weiterbildung der Erfindung weist die Verbindungsanordnung wenigstens ein durchgehendes Befestigungselement auf. Dabei sind die Stromschiene und das elektrisch isolierende Element sowie optional auch ein mit der Stromschiene in Verbindung stehendes elektrisches Bauteil gleichzeitig, das heißt mittels des wenigstens einen durchgehenden Befestigungselements, mit der Wand des Gehäuses verbindbar.

In vorteilhaften Ausführungsbeispielen umfasst die Verbindungsanordnung dabei wenigstens eine Schraube und/oder wenigstens eine Gewindestange und/oder wenigstens einen Niet und/oder wenigstens einen Pressbolzen, sowie jeweils dazugehörend wenigstens eine Mutter und/oder wenigstens eine Gewindehülse und/oder wenigstens eine Pressbuchse. Des Weiteren kann die Verbindungsanordnung auch eine Klebeverbindung umfassen. In alternativen Ausführungsbeispielen kann auch eine Kombination mehrerer der vorstehend genannten Befestigungselemente Verwendung finden. Besonders vorteilhaft ist die Verbindungsanordnung zu Recyclingzwecken auch wieder trennbar vom Gehäuse gestaltet.

In einem weiterhin vorteilhaften Ausführungsbeispiel weist die Verbindungsanordnung ein mit dem elektrisch isolierenden Element verbindbares Metallelement auf.

In einer vorteilhaften Weiterbildung der erfindungsgemäßen Befestigungsanordnung ist das elektrisch isolierende und thermisch sehr gut leitende Element von einem Kunststoffblock, einer Kunststoffscheibe oder einer bevorzugt auf die Stromschiene aufgespritzten Kunststoffschicht, beispielsweise aus Polypropylen (PP), Polyphthalamid (PPA), Polyamid (insbesondere PA 6, PA 66 oder PA 12), Thermoplastische Copolyester (COPE), Polyphenylen Sulfid (PPS), Liquid Crystal Polymer (LCP), Thermoplastische Elastomere (TPE), Polycarbonate/Acrylnitril Butadien Styrol (PC/ABS-Blend), Polyetheretherketon (PEEK), Polyetherimide (PEI) oder Polybutylenterephthalat (PBT) gebildet. Diesen Kunststoffen werden zur Verbesserung der thermischen Leitfähigkeit bevorzugt keramische und/oder mineralische Füllstoffe hinzugefügt, wie beispielsweise Aluminiumoxid oder Bornitrid. Beispiele für besonders geeignete Materialien für das elektrisch isolierende und thermisch sehr gut leitende Element sind:
- Laticonther^{®} 82 CP1 /800, PA12 mit thermischer Leitfähigkeit von 9.5 W/(m*K),
- Laticonther^{®} 62 CP6-V0HF1, PA 6 mit thermischer Leitfähigkeit von 4 W/(m*K),
- Laticonther^{®} 52 CP1/60, PPH mit thermischer Leitfähigkeit 6 W/(m*K),
- CoolPoly^{®} D5506, Thermally Conductive Liquid Crystalline Polymer (LCP) mit 10 W/(m*K) oder
- CoolPoly^{®} D3612, Thermally Conductive Polyamide (PA) mit 6 W/(m*K).
(Laticonther^{®} ist eine eingetragene Marke der LATI INDUSTRIA TERMOPLASTICI SPA, IT; CoolPoly^{®} ist eine eingetragene Marke der Ticona Polymers, Inc., US)

Das elektrisch isolierende und thermisch sehr gut leitende Element kann alternativ dazu auch von einem oxidischen oder nichtoxidischen Keramikmaterial gebildet werden.

Besonders geeignet sind hierbei beispielsweise von den oxidischen Keramikwerkstoffen:
- Aluminiumoxid,
- ZTA-Werkstoffe (Zirconia Toughened Alumina) oder
- ATZ-Werkstoffe (Alumina Toughened Zirconia).

Besonders geeignet sind hierbei beispielsweise von den nichtoxidischen Keramikwerkstoffen:
- Aluminiumnitrid,
- Siliciumcarbid oder
- Siliziumnitrid.

In einer weiteren vorteilhaften Ausführungsform ist das elektrisch isolierende Element als Hülse ausgebildet, die die Stromschiene und optional ein mit dieser verbundenes elektrische Bauteil gegenüber dem durchgehenden Befestigungselement isoliert. Die erfindungsgemäße Verbindungsanordnung ermöglicht dadurch zusätzlich auch vorteilhaft einen Ausgleich von Wärmedehnungen der Stromschiene. In alternativen Ausführungsbeispielen können auch mehrere elektrisch isolierende Elemente angeordnet sein. So kann beispielsweise zusätzlich zur Hülse auch eine Kunststoffscheibe oder eine Keramikplatte einen Teil der Verbindungsanordnung bilden.

In einer besonders vorteilhaften Weiterbildung ist das elektrisch isolierende Element gleichzeitig als Befestigungselement oder als Teil eines Befestigungselements ausgebildet.

Das elektrisch isolierende Element weist in einer weiterhin besonders vorteilhaften Weiterbildung wenigstens eine Bohrung auf. Diese wenigstens eine Bohrung kann dabei als Sackloch oder als Durchgangsbohrung zwischen zwei gegenüberliegenden Seiten des elektrisch isolierenden Elements ausgebildet sein. Sowohl die Durchgangsbohrung als auch die Sackbohrung kann dabei mit oder ohne Senkung ausgebildet sein.

Vorteilhaft ist die wenigstens eine Wand des Gehäuses als Kühlplatte ausgebildet ist. An einer Innenseite der Wand kann dabei wenigstens ein Sackloch zur Befestigung der Verbindungsanordnung am Gehäuse ausgebildet sein. Dabei kann das Sackloch als Gewinde zur Aufnahme einer Schraube oder Gewindestange oder mit einer glatten Oberfläche zur Aufnahme eines Niets oder Einpressbolzens ausgebildet sein. Die Verbindungsanordnung ist somit abhängig vom jeweiligen Ausführungsbeispiel schraubbar oder durch Verpressen oder durch Verkleben an der Wand des Gehäuses befestigbar. Aufgrund der Befestigung der Verbindungsanordnung an der Kühlplatte kann somit ein Wärmetransport von der Stromschiene und/oder vom elektrischen Bauteil zum Gehäuse erfolgen, wodurch sowohl eine aktive als auch eine passive Kühlung realisierbar ist.

Zudem ist durch die Wärmeabfuhr über die erfindungsgemäße Verbindungsanordnung auch eine Reduzierung der Leiterquerschnitte der Stromschiene möglich, was zu einer Reduzierung des Gesamtgewichts des bestückten Gehäuses führt.

Das Gehäuse wird insbesondere von einem Gehäuse einer Vorrichtung zur Energieverteilung und/oder zur Energieumwandlung gebildet, die in der Fachwelt manchmal auch als Power-Distribution-Unit (PDU) oder Power Distribution Module (PDM) bezeichnet wird, und wenigstens einen DC/DC-Wandler und weitere Hochvolt-Komponenten umfasst.

Nachfolgend sind Ausführungsbeispiele der Erfindung unter Bezugnahme auf die Zeichnungen näher erläutert. Es zeigt:
- Fig. 1: ein erstes Beispiel einer Verbindungsanordnung mit einem durchgehenden Befestigungselement;
- Fig. 2: ein zweites Beispiel einer Verbindungsanordnung mit einem durchgehenden Befestigungselement;
- Fig. 3: ein erstes erfindungsgemäßes Ausführungsbeispiel einer Verbindungsanordnung mit wenigstens zwei Befestigungselementen;
- Fig. 4: ein zweites erfindungsgemäßes Ausführungsbeispiel einer Verbindungsanordnung mit wenigstens zwei Befestigungselementen und
- Fig. 5: ein drittes erfindungsgemäßes Ausführungsbeispiel eines Gehäuses mit einer Verbindungsanordnung mit wenigstens zwei Befestigungselementen .

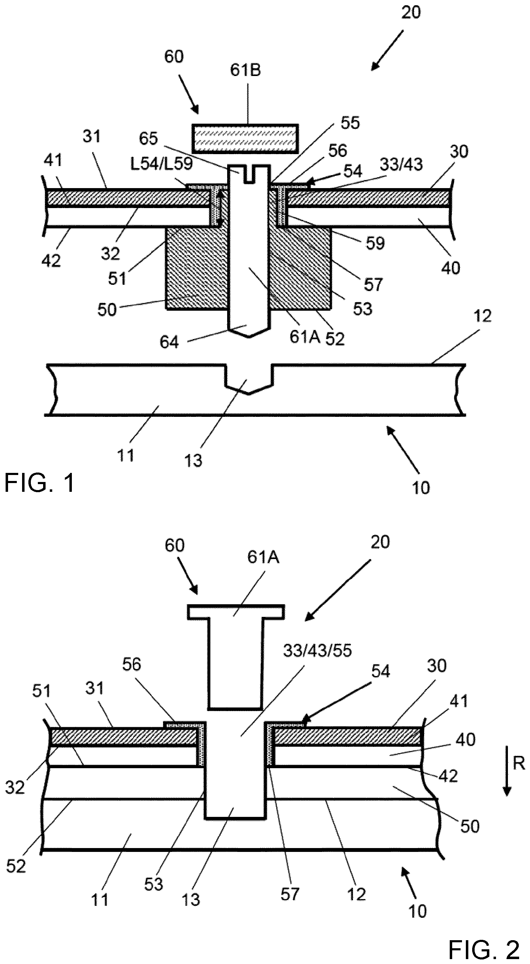

Die Figur 1 zeigt ein erstes Beispiel eines Gehäuses 10 mit einer Verbindungsanordnung 20 mit einem durchgehenden Befestigungselement 60. Ein elektrisches Bauelement 30 ist dabei oberhalb einer Stromschiene 40 angeordnet und diese wiederum oberhalb eines elektrisch isolierenden Elements 50, welches die Form eines Kunststoffblocks bildet. Da im Betrieb die Temperatur der Stromschiene bis auf 120°C ansteigen kann, ist erfindungsgemäß vorgesehen, dass das elektrisch isolierende Element 50 thermisch sehr gut leitend ausgebildet ist. Ein gut thermisch leitender Werkstoff hat beispielsweise eine Leitfähigkeit ab etwa 1,5 W/(m-K) oder mehr.

Das elektrisch isolierende und thermisch sehr gut leitende Element 50 ist in allen in den Figuren 1 bis 5 dargestellten Ausführungsbeispielen von einem Kunststoffblock, einer Kunststoffscheibe oder einer bevorzugt auf die Stromschiene 40 aufgespritzten Kunststoffschicht, beispielsweise aus Polypropylen (PP), Polyphthalamid (PPA), Polyamid (insbesondere PA 6, PA 66 oder PA 12), Thermoplastische Copolyester (COPE), Polyphenylen Sulfid (PPS), Liquid Crystal Polymer (LCP), Thermoplastische Elastomere (TPE), Polycarbonate/Acrylnitril Butadien Styrol (PC/ABS-Blend), Polyetheretherketon (PEEK), Polyetherimide (PEI) oder Polybutylenterephthalat (PBT) gebildet.

Diesen Kunststoffen werden zur Verbesserung der thermischen Leitfähigkeit bevorzugt keramische und/oder mineralische Füllstoffe hinzugefügt, wie beispielsweise Aluminiumoxid oder Bornitrid. Beispiele für besonders geeignete Materialien für das elektrisch isolierende und thermisch sehr gut leitende Element 50 sind:
- Laticonther^{®} 82 CP1/800, PA12 mit thermischer Leitfähigkeit von 9.5 W/(m*K),
- Laticonther^{®} 62 CP6-V0HF1, PA 6 mit thermischer Leitfähigkeit von 4 W/(m*K),
- Laticonther^{®} 52 CP1/60, PPH mit thermischer Leitfähigkeit 6 W/(m*K),
- CoolPoly^{®} D5506, Thermally Conductive Liquid Crystalline Polymer (LCP) mit 10 W/(m*K) oder
- CoolPoly^{®} D3612, Thermally Conductive Polyamide (PA) mit 6 W/(m*K).

Das elektrisch isolierende und thermisch sehr gut leitende Element 50 kann alternativ oder ergänzend dazu auch von einem oxidischen oder nichtoxidischen Keramikmaterial gebildet werden.

Besonders geeignet sind hierbei beispielsweise von den oxidischen Keramikwerkstoffen:
- Aluminiumoxid,
- ZTA-Werkstoffe (Zirconia Toughened Alumina) oder
- ATZ-Werkstoffe (Alumina Toughened Zirconia).

Besonders geeignet sind von den nichtoxidischen Keramikwerkstoffen beispielsweise:
- Aluminiumnitrid,
- Siliciumcarbid oder
- Siliziumnitrid.

Das elektrische Bauelement 30, die Stromschiene 40 sowie das elektrisch isolierende Element 50 weisen eine Bohrung 33 bzw. 43 bzw. 53 auf, die jeweils als Durchgangsbohrung ausgebildet ist. Bei der Montage wird eine Hülse 54 aus elektrisch isolierenden Material in einer Montagerichtung R durch die Bohrungen 33 und 43 hindurchgeführt, wodurch ein Kragen 56 der Hülse 54 auf einer ersten Seite 31 des elektrischen Bauteils 30 zur Anlage gebracht wird und ein unterer Rand 57 der Hülse 54 mit einer zweiten Seite 42 der Stromschiene 40 bündig abschließt. Die Hülse 54 ermöglicht vorteilhaft auch gleichzeitig einen Ausgleich von Wärmedehnungen der Stromschiene 40.

Das elektrisch isolierende Element 50 weist an einer ersten Seite 51 einen die Bohrung 53 umschließenden Schaft 59 auf, welcher innerhalb der Hülse 54 angeordnet ist. Dabei entspricht eine Länge L59 des Schafts 59 einer Länge L54 der Hülse 54. Somit liegt der untere Rand 57 der Hülse 54 ebenfalls auf der ersten Seite 51 des elektrisch isolierenden Elements 50 auf.

Das durchgehende Befestigungselement 60, welches in der Figur 1 von einem ersten Befestigungsmittel 61A gebildet ist, kann durch eine Bohrung 55 in der Hülse 54 und die Durchgangsbohrung 53 des elektrisch isolierenden Elements 50 hindurchgeführt werden.

Im gezeigten Beispiel ist das erste Befestigungsmittel 61A von einer Gewindestange gebildet. In alternativen Ausführungsbeispielen kann dieses auch von einer Schraube oder einem Niet oder einem Pressbolzen gebildet sein.

Die Befestigung des in Fig. 1 als Gewindestange ausgebildeten ersten Befestigungsmittels 61A durch die Durchgangsbohrung 53 des elektrisch isolierenden Elements 50 erfolgt im gezeigten Ausführungsbeispiel mittels Verschrauben. Hierzu ist an einem oberen Ende 65 ersten Befestigungsmittels 61A eine Aufnahme oder ein Ansatz für ein Werkzeug ausgebildet, der im in Fig. 1 gezeigten Beispiel von einem Schlitz für einen Schraubendreher gebildet wird.

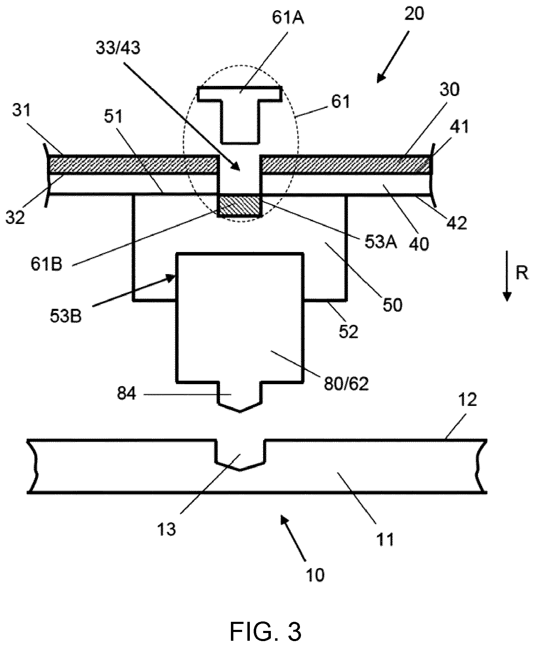

Alternativ ist das erste Befestigungsmittel 61A auch durch Einpressen, Kleben oder durch Umspritzen im elektrisch isolierenden Element 50 befestigbar, wie in Fig. 3 gezeigt.

Zur Befestigung der Verbindungsanordnung 20 an einer Wand 11 des Gehäuses 10 wird das erste Befestigungsmittel 61A in ein Sackloch 13 eingeführt, welches an einer Innenseite 12 der Wand 11 angeordnet ist. Das Sackloch 13 ist im gezeigten Ausführungsbeispiel als Gewindebohrung ausgebildet, so dass ein Gewinde 64 des ersten Befestigungsmittels 61A im Sackloch 13 befestigbar ist. Eine zweite Seite 52 des elektrisch isolierenden Elements 50 wird so an die Innenseite 12 der Wand 11 angepresst, welche erfindungsgemäß als Kühlplatte ausgebildet ist.

Um eine zuverlässige Verbindung der Verbindungsanordnung 20 an der Wand 11 des Gehäuses 12 zu gewährleisten, wird das obere Ende 65 des ersten Befestigungsmittels 61A mittels eines nach Art einer Mutter ausgebildeten zweiten Befestigungsmittels 61B fest verschraubt. Dadurch wird der Kragen 56 der Hülse 54 auf die erste Seite 31 des elektrischen Bauteils 30 und eine zweite Seite 32 des elektrischen Bauteils 30 auf eine erste Seite 41 der Stromschiene 40 gedrückt.

Durch den so ermöglichten Wärmetransport zwischen dem elektrischen Bauteil 30, der Stromschiene 40 und der Wand 11 des Gehäuses 10 erfolgt sowohl eine aktive als auch passive Kühlung. Dadurch kann ein Überhitzen der im Gehäuse 10 angeordneten elektrischen Komponenten 30 bzw. 40 vermieden werden.

Im in der Figur 2 gezeigten zweiten Beispiel einer Verbindungsanordnung 20 mit einem durchgehenden Befestigungselement 60 ist das elektrisch isolierende Element 50 als Kunststoffscheibe und/oder als Keramikplatte aus einem oder mehreren der bereits vorstehend beschriebenen Werkstoffe ausgebildet.

Auch in diesem Beispiel weisen das elektrische Bauelement 30, die Stromschiene 40 sowie das elektrisch isolierende Element 50 als Durchgangsbohrungen ausgebildete Bohrungen 33 bzw. 43 bzw. 53 auf. Bei der Montage wird die Hülse 54 in Montagerichtung R durch die Bohrungen 33 und 43 hindurchgeführt, wodurch der Kragen 56 der Hülse 54 auf der ersten Seite 31 des elektrischen Bauteils 30 zur Anlage gebracht wird und der untere Rand 57 der Hülse 54 mit der zweiten Seite 42 der Stromschiene 40 bündig abschließt. Die Hülse 54 ermöglicht zusätzlich auch vorteilhaft einen Ausgleich von Wärmedehnungen der Stromschiene 40.

Da das elektrisch isolierende Element 50 im gezeigten Beispiel in Form einer Platte ausgebildet ist, kann die Stromschiene 40 großflächig auf dem elektrisch isolierenden Element 50 aufliegen und somit über eine größere Fläche als im ersten gezeigten Ausführungsbeispiel die in der Stromschiene 40 erzeugte Wärme über das elektrisch isolierende Element 50 hin zu der als Kühlplatte ausgebildeten Wand 11 des Gehäuses 10 ableiten. Durch die Verwendung eines als Platte ausgebildeten elektrisch isolierenden Elements 50 ist zudem eine geringere Bauhöhe der Verbindungsanordnung 20 realisierbar.

Die Befestigung der Verbindungsanordnung 20 an der Wand 11 des Gehäuses 10 erfolgt auch im gezeigten Ausführungsbeispiel gemäß Fig. 2 mittels eines durchgehenden Befestigungselements 60, dessen Befestigungsmittel 61A als Niet und das Sackloch 13 in der Wand 11 somit mit einer glatten Oberfläche ausgebildet.

Das Verbinden der Verbindungsanordnung 20 mit der Wand 11 kann daher über Formschluss in Form von Kaltnieten oder über Kraftschluss in Form von Warmnieten erfolgen. Alternativ ist aber auch hierbei eine Befestigung durch eine Schraubverbindung möglich.

In der Figur 3 ist ein Ausführungsbeispiel einer Verbindungsanordnung 20 mit wenigstens zwei Befestigungselementen 61 und 62 gezeigt. Dabei wird das erste Befestigungselement 61 von einem ersten Befestigungsmittel 61A und einem zweiten Befestigungsmittel 61B und das Befestigungselement 62 von einem Metallelement 80 gebildet.

Das erste Befestigungsmittel 61A durchgreift die Bohrungen 33 und 43 des elektrischen Bauteils 30 und der Stromschiene 40 und greift in eine an der ersten Seite 51 des elektrisch isolierenden, gut wärmeleitenden Elements 50 ausgebildete Bohrung 53A. Diese ist als Sackloch ausgebildet, in dem ein zweites Befestigungsmittel 61B angeordnet ist. Das erste Befestigungsmittel 61A kann dabei als Schraube oder als Gewindestange oder als Pressbolzen ausgebildet sein. Das Befestigungsmittel 61B, welches als Gegenstück dient, kann beispielsweise als Mutter oder als Gewindehülse oder als Pressbuchse ausgebildet sein. Bei einer zumindest teilweisen Ausbildung aus Kunststoff - beispielsweise einer Ummantelung aus Kunststoff - kann das Befestigungsmittel 61B auch in diesem Ausführungsbeispiel vorteilhaft einen Ausgleich von Wärmedehnungen der Stromschiene 40 ermöglichen.

In einer zweiten Bohrung 53B auf der zweiten Seite 52 des elektrisch isolierenden Elements 50, welche ebenfalls als Sackloch ausgebildet ist, ist das Metallelement 80 angeordnet. Dabei kann das Metallelement 80 beispielsweise durch Umspritzen oder Einschrauben oder durch Kleben im elektrisch isolierenden Element 50 befestigt sein. Das elektrisch isolierende, gut wärmeleitende Element 50 ist im gezeigten Ausführungsbeispiel als Kunststoffblock ausgebildet.

Bei der Verbindungsanordnung 20 mit wenigstens zwei Befestigungselementen 61 und 62 ist keine Hülse 54 als isolierendes Element notwendig, welches das elektrische Bauteil 30 und die Stromschiene 40 gegenüber dem Befestigungselement 60 isoliert. Der direkte Kontakt zwischen durchgehendem Befestigungselement 60 und der Wand 11 des Gehäuses 10 ist bei dieser Verbindungsanordnung 20 nicht gegeben, weil das elektrisch isolierende, gut wärmeleitende Element 50 in diesem Fall keine Durchgangsbohrung aufweist und somit die Stromschiene 40 und das Befestigungselement 60 bzw. 61A gegenüber der Wand 11 vollständig isoliert.

Die Verbindungsanordnung 20 wird in Figur 3 mit der Wand 11 des Gehäuses 10 verbunden, indem ein Gewinde 84 des Metallelements 80 in das mit einer Gewindebohrung versehene Sackloch 13 eingeschraubt wird. Alternativ dazu kann die Schraubverbindung auch hier durch eine Pressverbindung oder eine Klebeverbindung ersetzt werden.

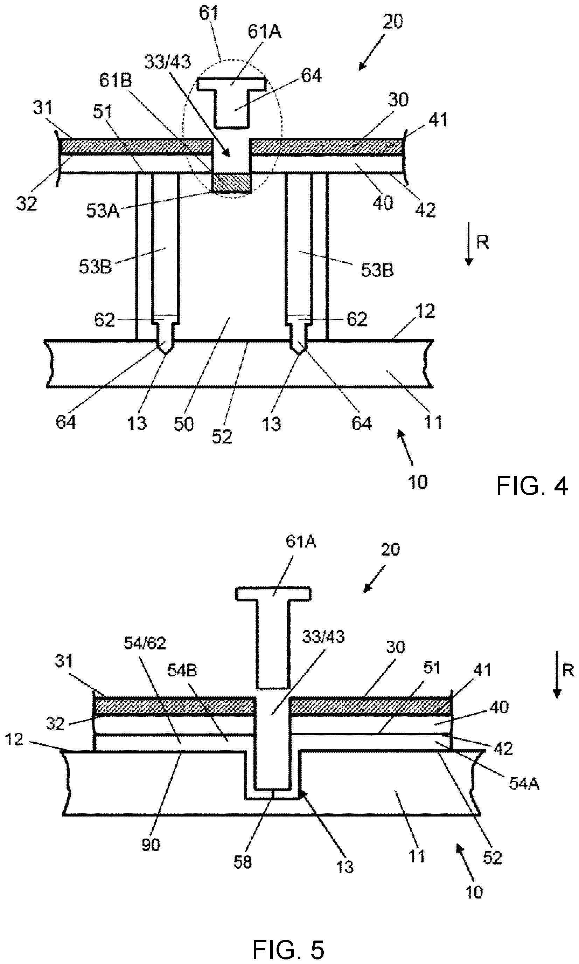

In Figur 4 ist ein zweites Ausführungsbeispiel einer Verbindungsanordnung 20 mit wenigstens zwei Befestigungselementen 61 und 62 gezeigt. Die Verbindung der Verbindungsanordnung 20 mit der Wand 11 des Gehäuses 10 erfolgt dabei in zwei Schritten. Im ersten Schritt wird das elektrisch isolierende Element 50 mittels wenigstens zwei zweiten Verbindungselementen 62 an der Wand 11 des Gehäuses befestigt. Hierzu werden diese in zwei im elektrisch isolierenden Element 50 vorgesehene Bohrungen 53B geführt, deren oberer Bereich im Durchmesser größer ist als eine im unteren Bereich liegende Durchtrittsbohrung. Die beiden zweiten Verbindungselemente 62 sind dabei bevorzugt als Schrauben ausgebildet. Die Verbindung von elektrischem Bauelement 30 und Stromschiene 40 mittels des ersten Befestigungselements 61 erfolgt analog zur Figur 3.

Das in der Figur 5 beschriebene Ausführungsbeispiel ist eine dritte Variante der Befestigung mittels wenigstens zwei Befestigungselementen 61 bzw. 62. Das erste Befestigungselement 61 ist in Figur 5 als Befestigungsmittel 61A beispielsweise mit einem Tannenbaumprofil zum Einpressen in eine entsprechend geformte Aufnahme ausgebildet. Des Weiteren ist das elektrisch isolierende Element 50 als Hülse 54 mit einer ersten Hülsenhälfte 54A und einer zweiten Hülsenhälfte 54B ausgebildet. Die Hülsenhälften 54A bzw. 54B sind an einer Stoßfuge 58 miteinander verbindbar, was beispielsweise mittels einer Klebung oder durch Verschweißen erfolgen kann. Die Hülse 54 kann ebenso auch einteilig ausgebildet und in das Sackloch 13 in der Wand 11 eingepresst sein. Die innere Oberfläche der Hülse 54 ist bevorzugt mit einem zum Tannenbaumprofil des ersten Befestigungselements 61 gegenläufigen Tannenbaumprofil ausgebildet, so dass die Profile sich beim Einpressen formschlüssig ineinander verhaken. Alternativ sind auch hier wieder andere Befestigungsformen, wie ein Einschrauben in eine in der Hülse 54 eingeformte oder in dieser aufgenommenen Mutter möglich.

Die Hülse 54 ist im gezeigten Ausführungsbeispiel gemäß Fig. 5 gleichzeitig als elektrisch isolierendes Element 50 und als zweites Befestigungselement 62 ausgebildet. Eine Klebung 90 verbindet die zweite Seite 52 des elektrisch isolierenden Elements 50 mit der Innenseite 12 der Wand 11 des Gehäuses 10. Die Hülse 54 ermöglicht auch in diesem Ausführungsbeispiel vorteilhaft einen Ausgleich von Wärmedehnungen der Stromschiene.

Gemäß einer weiteren, nicht dargestellten Ausführungsform kann das elektrisch isolierende, gut Wärme leitende Element 50 auch von einer Schicht aus Kunststoff und/oder Keramik gebildet sein, die beispielsweise als Umspritzung die Stromschiene 50 außerhalb von deren vorgesehenen Kontaktbereichen partiell oder vollständig umgeben kann.

## Patentansprüche

1. Verbindungsanordnung zum Verbinden einer Stromschiene (40) mit einem Gehäuse (10) für elektrische Bauteile (30), umfassend die Stromschiene (40) und wenigstens eine Wand (11) des Gehäuses (10) sowie wenigstens ein elektrisch isolierendes Element (50), wobei die Verbindungsanordnung (20) wenigstens ein Befestigungselement (60; 61A; 62) zur Verbindung mit der Wand (11) des Gehäuses (10) aufweist und das wenigstens eine elektrisch isolierende Element (50) aus einem thermisch gut leitenden Werkstoff mit einer Wärmeleitfähigkeit von mehr als 1,5 W/(m·K) ausgebildet ist
**dadurch gekennzeichnet, dass** die Verbindungsanordnung (20) wenigstens zwei Befestigungselemente (60; 61A; 62) aufweist, wobei ein erstes Befestigungselement (61A), die Stromschiene (40) und das elektrisch isolierende Element (50) miteinander verbindet und wenigstens ein zweites Befestigungselement (62) das elektrisch isolierende Element (50) mit der Wand (11) des Gehäuses (10) verbindet.

2. Verbindungsanordnung nach Anspruch 1, **dadurch gekennzeichnet, dass** mit der Stromschiene (40) gleichzeitig ein elektrisches Bauteil (30) an der Wand (11) des Gehäuses (10) befestigbar ist.

3. Verbindungsanordnung nach Anspruch 1 oder 2, **dadurch gekennzeichnet, dass** die Verbindungsanordnung (20) wenigstens ein durchgehendes Befestigungselement (60; 61A) zur Verbindung der Stromschiene (40), des elektrisch isolierenden Elements (50) und der Wand (11) des Gehäuses (10) aufweist.

4. Verbindungsanordnung nach einem der vorhergehenden Ansprüche, **dadurch gekennzeichnet, dass** die Verbindungsanordnung (20) als Befestigungselement (60) eine Schraube, eine Gewindestange, einen Niet oder einen Pressbolzen umfasst.

5. Verbindungsanordnung nach einem der vorhergehenden Ansprüche, **dadurch gekennzeichnet, dass** die Verbindungsanordnung (20) eine Mutter, eine Gewindehülse oder eine Pressbuche umfasst.

6. Verbindungsanordnung nach einem der vorhergehenden Ansprüche, **dadurch gekennzeichnet, dass** die Verbindungsanordnung (20) eine Klebeverbindung (90) umfasst.

7. Verbindungsanordnung nach einem der vorhergehenden Ansprüche, **dadurch gekennzeichnet, dass** die Verbindungsanordnung (20) wenigstens ein mit dem elektrisch isolierenden Element (50) verbindbares Metallelement (80) aufweist.

8. Verbindungsanordnung nach einem der vorhergehenden Ansprüche, **dadurch gekennzeichnet, dass** das elektrisch isolierende Element (50) von einem Kunststoffblock oder einer Kunststoffscheibe oder einer Keramikplatte gebildet ist.

9. Verbindungsanordnung nach einem der vorhergehenden Ansprüche, **dadurch gekennzeichnet, dass** das elektrisch isolierende Element (50) als Hülse (54) ausgebildet ist, die die Stromschiene (40) gegenüber dem Befestigungselement (60) isoliert.

10. Verbindungsanordnung nach einem der vorhergehenden Ansprüche, **dadurch gekennzeichnet, dass** das elektrisch isolierende Element (50) gleichzeitig als Befestigungselement (62) ausgebildet ist.

11. Verbindungsanordnung nach einem der vorhergehenden Ansprüche, **dadurch gekennzeichnet, dass** das elektrisch isolierende Element (50) als wenigstens eine Schicht fest an der Stromschiene (40) angeordnet ist.

12. Verbindungsanordnung nach einem der vorhergehenden Ansprüche, **dadurch gekennzeichnet, dass** die Wand (11) des Gehäuses (10) als Kühlplatte ausgebildet ist.

13. Verbindungsanordnung nach einem der vorhergehenden Ansprüche, **dadurch gekennzeichnet, dass** die Verbindungsanordnung (20) wenigstens ein Element (54; 61B) aufweist, das eine Kompensation einer Wärmedehnung der Stromschiene (40) ermöglicht.

14. Verbindungsanordnung nach einem der vorhergehenden Ansprüche, **dadurch gekennzeichnet, dass** an einer Innenseite (12) der Wand (11) wenigstens ein Sackloch (13) zur Befestigung der Verbindungsanordnung (20) am Gehäuse (10) ausgebildet ist.

## Claims

1. A connection arrangement for connecting a busbar (40 to a housing (10) for electrical components (30), comprising the busbar (40) and at least one wall (11) of the housing (10), and at least one electrically insulating element (50), wherein the connection arrangement (20) has at least one fastening element (60; 61A; 62) for connection to the wall (11) of the housing (10), and the at least one electrically insulating element (50) is made of a material that has good thermal conductivity, of more than 1,5 W/(m·K) **characterized in that** the connection arrangement (20) has at least two fastening elements (60; 61A; 62), wherein a first fastening element (61A) connects the busbar (40) and the electrically insulating element (50) to one another, and a second fastening element (62) connects the electrically insulating element (50) to the wall (11) of the housing (10).

2. The connection arrangement as claimed in claim 1, **characterized in that** an electrical component (30) can be simultaneously fastened, with the busbar (40), to the wall (11) of the housing (10).

3. The connection arrangement as claimed in claim 1 or 2, **characterized in that** the connection arrangement (20) has at least one through-going fastening element (60; 61A) for connecting the busbar (40), the electrically insulating element (50 and the wall (11) of the housing (10).

4. The connection arrangement as claimed in any one of the preceding claims, **characterized in that** the connection arrangement (20) comprises a screw, a threaded rod, a rivet or a clamping bolt as a fastening element (60).

5. The connection arrangement as claimed in any one of the preceding claims, **characterized in that** the connection arrangement (20) comprises a nut, a threaded sleeve or a press bushing.

6. The connection arrangement as claimed in any one of the preceding claims, **characterized in that** the connection arrangement (20) comprises an adhesive bond (90).

7. The connection arrangement as claimed in any one of the preceding claims, **characterized in that** the connection arrangement (20) has at least one metal element (80) that can be connected to the electrically insulating element (50).

8. The connection arrangement as claimed in any one of the preceding claims, **characterized in that** the electrically insulating element (50) is formed by a plastic block or a plastic disk or a ceramic plate.

9. The connection arrangement as claimed in any one of the preceding claims, **characterized in that** the electrically insulating element (50) is realized as a sleeve (54) that insulates the busbar (40) from the fastening element (60).

10. The connection arrangement as claimed in any one of the preceding claims, **characterized in that** the electrically insulating element (50) is simultaneously realized as a fastening element (62).

11. The connection arrangement as claimed in any one of the preceding claims, **characterized in that** the electrically insulating element (50) is fixedly arranged, as at least one layer, on the busbar (40).

12. The connection arrangement as claimed in any one of the preceding claims, **characterized in that** the wall (11) of the housing (10) is realized as a cooling plate.

13. The connection arrangement as claimed in any one of the preceding claims, **characterized in that** the connection arrangement (20) has at least one element (54; 61B) that allows compensation of thermal expansion of the busbar (40).

14. The connection arrangement as claimed in any one of the preceding claims, **characterized in that** realized on an inner side (12) of the wall (11) there is at least one blind hole (13) for fastening the connection arrangement (20) to the housing (10).

## Revendications

1. Système de connexion pour connecter une barre omnibus (40) à un boîtier (10) pour composants électriques (30), comprenant la barre omnibus (40) et au moins une paroi (11) du boîtier (10) ainsi qu'au moins un élément électriquement isolant (50), dans lequel le système de connexion (20) comprend au moins un élément de fixation (60 ; 61A ; 62) pour la connexion avec la paroi (11) du boîtier (10) et l'au moins un élément électriquement isolant (50) est réalisé en un matériau ayant une bonne conductivité thermique, de plus de 1,5 W/(m-K)
**caractérisé en ce que** le système de connexion (20) comprend au moins deux éléments de fixation (60 ; 61A ; 62), dans lequel un premier élément de fixation (61A) relie la barre omnibus (40) et l'élément électriquement isolant (50) et au moins un deuxième élément de fixation (62) relie l'élément électriquement isolant (50) à la paroi (11) du boîtier (10).

2. Système de connexion selon la revendication 1, **caractérisé en ce qu'un** composant électrique (30) est fixable simultanément avec la barre omnibus (40) sur la paroi (11) du boîtier (10).

3. Système de connexion selon la revendication 1 ou 2, **caractérisé en ce que** le système de connexion (20) comprend au moins un élément de fixation traversant (60 ; 61A) pour relier la barre omnibus (40), l'élément électriquement isolant (50) et la paroi (11) du boîtier (10).

4. Système de connexion selon l'une des revendications précédentes, **caractérisé en ce que** le système de connexion (20) comprend comme élément de fixation (60) une vis, une tige filetée, un rivet ou un goujon à sertir à la presse.

5. Système de connexion selon l'une des revendications précédentes, **caractérisé en ce que** le système de connexion (20) comprend un écrou, un manchon fileté ou un manchon à sertir.

6. Système de connexion selon l'une des revendications précédentes, **caractérisé en ce que** le système de connexion (20) comprend un joint adhésif (90).

7. Système de connexion selon l'une des revendications précédentes, **caractérisé en ce que** le système de connexion (20) comprend au moins un élément métallique (80) qui est connectable à l'élément électriquement isolant (50).

8. Système de connexion selon l'une des revendications précédentes, **caractérisé en ce que** l'élément électriquement isolant (50) est formé d'un bloc ou d'un disque en matière plastique ou d'une plaque en céramique.

9. Système de connexion selon l'une des revendications précédentes, **caractérisé en ce que** l'élément électriquement isolant (50) se présente sous la forme d'un manchon (54) qui isole la barre omnibus (40) par rapport à l'élément de fixation (60).

10. Système de connexion selon l'une des revendications précédentes, **caractérisé en ce que** l'élément électriquement isolant (50) est également configuré en tant qu'élément de fixation (62).

11. Système de connexion selon l'une des revendications précédentes, **caractérisé en ce que** l'élément électriquement isolant (50) est disposé de manière fixe, sous forme d'au moins une couche, sur la barre omnibus (40).

12. Système de connexion selon l'une des revendications précédentes, **caractérisé en ce que** la paroi (11) du boîtier (10) est conçue comme une plaque de refroidissement.

13. Système de connexion selon l'une des revendications précédentes, **caractérisé en ce que** le système de connexion (20) comporte au moins un élément (54 ; 61B) permettant de compenser une dilatation thermique de la barre omnibus (40).

14. Système de connexion selon l'une des revendications précédentes, **caractérisé en ce qu'**au moins un trou borgne (13) est formé sur une face interne (12) de la paroi (11) pour la fixation du système de connexion (20) au boîtier (10).
